# EUROPÄISCHE PATENTANMELDUNG

(11) **EP 1 981 326 A2**
(43) Veröffentlichungstag der Anmeldung: **15.10.2008**
(21) Anmeldenummer: 08101981.2
(22) Anmeldetag: 26.02.2008
(51) Int. Cl.: H05K 13/02

(54) **Zuordnung zwischen Gebinde-Aufnahmefach und Bauelement-Zuführvorrichtung mittels Führungselement**

(30) Priorität: 11.04.2007 DE 102007017120
(71) Anmelder: SIEMENS AKTIENGESELLSCHAFT, 80333 München (DE)
(72) Erfinder: Eschenweck, Friedrich, 85622 Feldkirchen (DE)
(74) Vertreter: Maier, Daniel Oliver

(57) **Zusammenfassung**

Es wird ein Zuführsystem (320) zum sequentiellen Bereitstellen von elektronischen Bauelementen für eine Bestückvorrichtung beschrieben. Das Zuführsystem (320) weist auf eine Gebinde-Aufnahmevorrichtung (325) mit einer Mehrzahl von Aufnahmebereichen (326) zum Aufnehmen jeweils eines mit elektronischen Bauelementen befüllten Gebindes (350) und zumindest eine Bauelement-Zuführvorrichtung (380) zum sequentiellen Zuführen von in einem Gebinde (350) aufbewahrten Bauelementen. Das Zuführsystem (320) weist ferner auf ein Führungselement (385), welches sich zumindest teilweise von der Bauelement-Zuführvorrichtung (380) zu einem Aufnahmebereich (326) erstreckt, an der Bauelement-Zuführvorrichtung (380) fixiert und mit einem der Bauelement-Zuführvorrichtung (380) abgewandten Ende mit der Gebinde-Aufnahmevorrichtung (125a, 125b, 325) verbunden ist, so dass der Bauelement-Zuführvorrichtung (380) ein bestimmter Aufnahmebereich (326) der Gebinde-Aufnahmevorrichtung (325) zugeordnet ist. Es wird ferner eine Bestückvorrichtung zum Bestücken von Leiterplatten beschrieben, welche ein Zuführsystem (320) des genannten Typs aufweist. Ferner wird ein Verfahren zum Bereitstellen von in einem Bauelement-Gurt (352) aufbewahrten elektronischen Bauelementen an einer Abholposition unter Verwendung des genannten Zuführsystems (320) beschrieben.

## Beschreibung

Die vorliegende Erfindung betrifft die automatische Bestückung von Bauelementeträger bzw. Leiterplatten mit elektronischen Bauelementen. Die Erfindung betrifft insbesondere ein Zuführsystem zum sequentiellen Bereitstellen von elektronischen Bauelementen für eine Bestückvorrichtung. Die Erfindung betrifft ferner eine Bestückvorrichtung, welche ein Bauelement-Zuführsystem des oben beschriebenen Typs aufweist. Außerdem betrifft die Erfindung ein Verfahren zum Bereitstellen von in einem Bauelement-Gurt aufbewahrten elektronischen Bauelementen an einer Abholposition unter Verwendung eines Zuführsystems des oben beschriebenen Typs.

Bei der automatischen Bestückung von Bauelementeträgern bzw. Leiterplatten mit elektronischen Bauelementen werden Bauelemente an Abholpositionen bereitgestellt. Von dort werden sie mittels eines Bestückkopfes abgeholt und auf vorbestimmte Bestückpositionen auf einer Leiterplatte aufgesetzt. Um den Bestückungsprozess zu beschleunigen, erfolgt die Zuführung von mehreren elektronischen Bauelemente parallel an mehrere Abholpositionen, von denen die Bauelemente beispielsweise mittel eines so genannten Mehrfach-Bestückkopfes abgeholt und nach einem gemeinsamen Transport zu einem Bestückbereich nacheinander auf der Leiterplatte aufgesetzt werden.

Um eine fehlerlose Bestückung zu gewährleisten, muss sichergestellt werden, dass auch tatsächlich der jeweils korrekte Bauelement-Typ an der entsprechenden Abholposition bereitgestellt wird. Dies erfolgt im Rahmen einer so genannten Rüstverifikation, bei der beispielsweise unter Verwendung von Barcode-Lesegeräten die Gebinde und damit ein darin befindlicher Typ von Bauelement eindeutig identifiziert werden. Ferner kann eine Zuordnung zwischen einem Gebinde und einer bestimmten Bauelement-Zuführvorrichtung überprüft werden, welche die entsprechenden Bauelemente an jeweils einer fest zugeordneten Abholposition bereitstellen.

Aus der DE 101 19 232 C1 ist es bekannt, als Spulenkörper ausgebildete Gebinde mit jeweils einem RFID-Chip (Radio Frequency Identification-Chip) auszustatten. Auf diese Weise kann mittels einer Funkübertragung zwischen dem RFID-Chip und einer RFID-Leseeinrichtung das jeweilige Gebinde und damit auch die elektronischen Bauelemente, die in einem auf dem Spulenkörper aufgewickelten Bauelement-Gurt aufbewahrt sind, eindeutig identifiziert werden.

Aus der WO 2005/020656 A2 ist ein Zuführsystem für elektronische Bauelemente bekannt, welche in mehreren jeweils auf einem Spulenkörper aufgewickelten Bauelement-Gurten aufbewahrt sind. Die Spulenkörper sind jeweils mit einem RFID-Chip versehen, auf dem bauelement-bezogene Daten gespeichert werden können. Um eine Zuordnung zwischen einer bestimmten Zuführspur bzw. einer bestimmten Bauelement-Abholposition auf der einen Seite und einem Spulenkörper-Aufnahmebereich, der in einem sog. Gurtcontainer vorhanden ist, auf der anderen Seite überprüfen zu können, ist in jedem Aufnahmebereich ein RFID-Lesegerät vorgesehen. Auf diese Weise können sowohl die jeweiligen Spulenkörper bzw. die darin befindlichen Bauelemente als auch der jeweilige Spulenkörper-Aufnahmebereich identifiziert werden. Diese Daten können für eine automatische Rüstkontrolle herangezogen werden.

Aus der US 6,340,132 B1 ist ein Bauelement-Zuführsystem bekannt, welches eine Bauelement-Zuführvorrichtung und eine Halterung zum Aufnehmen eines als Spulenkörper ausgebildeten Gebindes aufweist. Die Halterung ist direkt an der Bauelement-Zuführvorrichtung angebracht, so dass in Bezug auf die Bauelement-Zuführung aufgrund der räumlichen Nähe von Zuführvorrichtung und Halterung automatisch eine eindeutige Zuordnung zwischen Zuführvorrichtung und Halterung gegeben ist. Dieses Bauelement-Zuführsystem hat jedoch den Nachteil, dass aufgrund der kompakten Bauweise ein erstmaliges Einfädeln eines Bauelement-Gurtes in die Zuführvorrichtung vergleichsweise umständlich ist. Außerdem stellt sich im Falle eines zumindest annähernd entleerten Gebindes ein erforderlicher Spleißvorgang, bei dem an das Ende eines ersten Gurtes der Anfang eines zweiten Gurtes angefügt wird, aufgrund der großen räumlichen Nähe von Halterung und Zuführvorrichtung ebenfalls als relativ umständlich dar.

Aus der US 2003/0046808 A1 ist ein Zuführsystem bekannt, welches zum sequentiellen Bereitstellen von elektronischen Bauteilen geeignet ist. Dieses Zuführsystem weist eine Gebinde-Aufnahmevorrichtung mit mehreren Aufnahmebereichen zum Aufnehmen von Spulenkörpern sowie eine Bauelement-Zuführvorrichtung auf. Dieses Zuführsystem hat jedoch den Nachteil, dass den Gebinden (z.B. Bauelement-Gurtspulen) vor dem Laden in die Gebinde-Aufnahmevorrichtung sogenannte Gurtführelemente zugeordnet bzw. an diesen angebracht werden. Nach dem Einbringen der Gurtspulen in das Zuführsystem werden diese Gurtführelemente dann nahe bei den Antriebsrädern der Bauelement-Zuführvorrichtung eingehängt, wodurch es nur schwer möglich ist, auf einfache und rasche Weise bestimmte Aufnahmebereiche bestimmten Bauelement-Zuführvorrichtungen zuzuordnen. Das ist insbesondere dann der Fall, wenn die Gebinde-Aufnahmevorrichtung tiefer gelegen (z.B. bodennahe) oder weiter entfernt von der Bauelement-Zuführvorrichtung angebracht ist. Auch der Austausch von leeren Gebinden bzw. Gebinden, die für einen Bestückungsprozess nicht mehr benötigt werden, gestaltet sich bei diesem Zuführsystem - beispielsweise durch ein Aus- und Einhängen der Gurtführelemente - relativ aufwendig.

Der Erfindung liegt die Aufgabe zugrunde ein Bauelement-Zuführsystem zu schaffen, welches zum einen ein einfaches Anfügen von Bauelement-Gurten ermöglicht und welches zum anderen eine eindeutige Zuordnung zwischen einem Gebinde und einer bestimmten Bauelement-Zuführvorrichtung gewährleistet.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird ein Zuführsystem zum sequentiellen Bereitstellen von elektronischen Bauelementen für eine Bestückvorrichtung beschrieben. Das Bauelement-Zuführsystem weist auf (a) eine Gebinde-Aufnahmevorrichtung mit einer Mehrzahl von Aufnahmebereichen zum Aufnehmen jeweils eines mit elektronischen Bauelementen befüllten Gebindes, (b) zumindest eine Bauelement-Zuführvorrichtung zum sequentiellen Zuführen von in einem Gebinde aufbewahrten Bauelementen und (c) ein Führungselement, welches sich zumindest teilweise von der Bauelement-Zuführvorrichtung zu einem Aufnahmebereich erstreckt, an der Bauelement-Zuführvorrichtung fixiert und mit einem der Bauelement-Zuführvorrichtung abgewandten Ende mit der Gebinde-Aufnahmevorrichtung verbunden ist, so dass der Bauelement-Zuführvorrichtung ein bestimmter Aufnahmebereich der Gebinde-Aufnahmevorrichtung zugeordnet ist.

Dem beschriebenen Zuführsystem liegt die Erkenntnis zugrunde, dass durch die Verwendung eines mechanischen Führungselements, welches sich zwischen der Gebinde-Aufnahmevorrichtung und der Bauelement-Zuführvorrichtung erstreckt und Verbindungen mit sowohl der Gebinde-Aufnahmevorrichtung als auch der Bauelement-Zuführvorrichtung aufweist, auf einfache Weise eine feste Zuordnung zwischen den einzelnen Zuführvorrichtungen und den jeweiligen Gebinden hergestellt werden kann.

Dabei ist das Führungselement bevorzugt in nicht lösbarer Weise an der Bauelement-Zuführvorrichtung fixiert. Die Kopplung des Führungselements mit der Gebinde-Aufnahmevorrichtung bzw. mit einem bestimmten Aufnahmebereich der Gebinde-Aufnahmevorrichtung kann bevorzugt mittels Einhängen bzw. Verankern erfolgen. Dabei wird das der Bauelement-Zuführvorrichtung abgewandte Ende des Führungselements in lösbarer Weise mit der Gebinde-Aufnahmevorrichtung verbunden.

Die Verwendung des beschriebenen Führungselements hat den Vorteil, dass auf einfache und effektive Weise eine in Bezug auf den Bauelementtyp zwar korrekte, in Bezug auf die Betriebssicherheit aber sehr problematische Rüstung eines Bestückautomaten verhindert wird. Bei einer derartigen Rüstung, welche in der Praxis häufig vorkommt, sind zumindest zwei in unterschiedlichen Aufnahmebereichen befindliche Gebinde miteinander vertauscht. Dabei wird ein korrektes Zuführen der Bauelemente bzgl. ihres Typs dadurch erreicht, dass die entsprechenden Bauelement-Gurte über Kreuz zu den entsprechenden Zuführvorrichtungen verlaufen. Bei einer derartigen Überkreuzung der Bauelement-Gurte ist eine Beschädigung der Gurte jedoch nicht unwahrscheinlich, so dass die Prozesssicherheit des gesamten Bestückungsprozesses reduziert ist.

Das beschriebene Bauelement-Zuführsystem kann mehrere Bauelement-Zuführvorrichtungen aufweisen, so dass gleichzeitig mehrere Bauelemente an bevorzugt zueinander benachbarten Abholpositionen bereitgestellt werden können. Dabei können auch mehrere Führungselemente vorgesehen sein, so dass zumindest einige der Aufnahmebereiche mittels eines Führungselements fest einer bestimmter Bauelement-Zuführvorrichtung zugeordnet sind.

Das Führungselement kann einerseits eine gewisse Steifigkeit aufweisen, so dass es nicht zur Seite weg bewegt werden kann. Auf diese Weise ist sichergestellt, dass eine Bedienperson beim Zusammenstellen des beschriebenen Bauelement-Zuführsystems das Führungselement auch tatsächlich mit dem korrekten Aufnahmebereich koppelt.

Das Führungselement kann andererseits jedoch eine gewisse Flexibilität aufweist, um beispielsweise ein Einhängen des der Bauelement-Zuführvorrichtung abgewandten Ende des Führungselements zu erleichtern. Eine eindeutige Zuordnung zwischen einem Gebinde und einer bestimmten Bauelement-Zuführvorrichtung kann dadurch gewährleistet werden, dass verschiedene Kupplungsformen zwischen Führungselement und Gebinde-Aufnahmevorrichtung verwendet werden, so dass ein Führungselement nur mit einem der Aufnahmebereiche verbunden werden kann.

Gemäß einem Ausführungsbeispiel der Erfindung nach Anspruch 2 sind die Aufnahmebereiche derart geformt, dass jeweils ein als Spulenkörper ausgebildetes Gebinde einbringbar ist.

Das beschriebene Bauelement-Zuführsystem kann somit in Verbindung mit Gebindeformen betrieben werden, die in der Praxis besonders häufig zum Bereitstellen von elektronischen Bauelementen verwendet werden. Ein Spulenkörper dient dabei der Platz sparenden Aufwicklung von sog. Bauelement-Gurten. Im Laufe einer sequentiellen Bauelement-Bereitstellung werden diese Gurte dann langsam von dem Spulenkörper abgewickelt. Auf diese Weise können quasi kontinuierlich elektronische Bauelemente an einer Abholposition bereitgestellt werden, welche Bauelemente sich in sog. Guttaschen befinden. Um ein unbeabsichtigtes Herausfallen der Bauelemente zu verhindern, kann in bekannter Weise eine Deckfolie vorgesehen sein, die den mit Bauelementen befüllten Gurt bedeckt. Die Abdeckfolie wird dann unmittelbar vor der Bauelement-Entnahme durch einen Bestückkopf von einer sog. Deckfolien-Abzugseinrichtung abgezogen.

Gemäß einem weiteren Ausführungsbeispiel der Erfindung nach Anspruch 3 weist das Führungselement einen Kanal auf, in dem ein von einem Gebinde abgewickelter und der Bauelement-Zuführvorrichtung zuzuführender Bauelement-Gurt führbar ist.

Der Kanal stellt somit einen Leitkanal für einen von einem Gebinde abgewickelten Bauelement-Gurt dar, so dass sichergestellt wird, dass der abgewickelte Gurt auch tatsächlich zu der entsprechenden Zuführvorrichtung transferiert wird. Ein versehentliches oder auch ein beabsichtigtes Überkreuzen von verschiedenen Bauelement-Gurten kann somit auf einfache und effektive Weise verhindert werden.

Der Kanal kann ein entlang einer Umlaufrichtung vollständig geschlossener Hohlkörper sein, der für den Bauelement-Gurt eine Art Tunnel darstellt. Ebenso kann der Kanal jedoch auch ein offenes Gebilde sein, welches eine zuverlässige Führung eines Bauelement-Gurts ermöglicht.

Gemäß Anspruch 4 weist das Zuführsystem zusätzlich eine Antenne auf, welche relativ zu dem Führungselement derart angeordnet ist, dass ein in dem Bauelement-Gurt befindlicher Datenträger auslesbar ist. Dies hat den Vorteil, dass Informationen über die in dem Bauelement-Gurt enthaltenen elektronischen Bauelemente auf einfache und sichere Weise ausgelesen werden können. Zu diesem Zweck kann die Antenne mit einer entsprechenden Leseeinrichtung gekoppelt sein, die diese bauelement-bezogenen Daten an eine zentrale Steuereinheit eines Bestückautomaten übermittelt. Selbstverständlich kann die Leseeinrichtung auch in einer zentralen Steuereinheit integriert sein.

Der Datenträger kann in einem Endbereich des Bauelement-Gurtes angeordnet sein. Eine Erfassung dieses Datenträgers mit der Antenne kann beispielsweise eine Bedienperson anweisen, rechtzeitig einen weiteren Gurt anzukoppeln, so dass die erforderlichen Bauelemente nicht ausgehen und eine unterbrechungsfreie Bereitstellung von Bauelementen und damit eine quasi-kontinuierliche Bestückung möglich ist. Ebenso kann der Datenträger auch an anderen Stellen entlang des Bauelement-Gurtes angeordnet sein und beispielsweise Informationen über die noch zur Verfügung stehenden Bauelemente enthalten. Auf diese Weise kann einer Bedienperson bereits frühzeitig angezeigt werden, wann ein Ankoppeln eines weiteren Bauelement-Gurtes erforderlich sein wird.

Gemäß Anspruch 5 weist die Antenne eine ringartige Form auf, welche das Führungselement umgibt. Auf diese Weise kann eine hohe Übertragungssicherheit zwischen einem in dem Gurt befindlichen Datenträger und einer mit der Antenne gekoppelten Leseeinrichtung gewährleistet werden.

Mit dem Anspruch 6 wird eine Bestückvorrichtung zum Bestücken von Leiterplatten mit elektronischen Bauelementen beschrieben. Die beschriebene Bestückvorrichtung weist auf ein Zuführsystem des oben beschriebenen Typs.

Der beschriebenen Bestückvorrichtung liegt die Erkenntnis zugrunde, dass durch die Verwendung des oben beschriebenen Bauelement-Zuführsystems eine verbesserte Prozesssicherheit eines Bestückautomaten insbesondere bezüglich der Zuführung des korrekten Bauelement-Typs an die entsprechende Bauelement-Zuführvorrichtung gewährleistet werden kann.

Insbesondere in Verbindung mit der oben beschriebenen Antenne kann in der Bestückvorrichtung stets auf einfache Weise festgestellt werden, ob mittels der zumindest einen Bauelement-Zuführvorrichtung auch tatsächlich der vorgesehene Typ von Bauelement zugeführt wird.

Mit dem Anspruch 7 wird ein Verfahren zum Bereitstellen von in einem Bauelement-Gurt aufbewahrten elektronischen Bauelementen an einer Abholposition beschrieben. Dabei wird ein Zuführsystem des oben beschriebenen Typs verwendet. Das Verfahren weist auf (a) Abwickeln des Bauelement-Gurtes von einem Spulenkörper, welcher sich in einem Aufnahmebereich der Gebinde-Aufnahmevorrichtung befindet, (b) Führen des abgewickelten Bauelement-Gurtes durch das Führungselement, und (c) Zuführen des geführten Bauelement-Gurtes an die Bauelement-Zuführvorrichtung.

Dem genannten Verfahren liegt die Erkenntnis zugrunde, dass die Verwendung eines mechanischen Führungselements auf einfache Weise eine lückenlose und fehlerfreie Zuordnung zwischen dem Gebinde bzw. dem in dem Gebinde aufbewahrten Bauelement und der entsprechenden Bauelement-Zuführvorrichtung bzw. der durch die Zuführvorrichtung definierten Bauelement-Zuführspur sicherstellt. Auf diese Weise kann die Prozesssicherheit eines Bestückautomaten erheblich verbessert werden.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

Figur 1 zeigt ein Bestücksystem, welches zwei entlang einer Leiterplatten-Transportstrecke angeordnete Bestückautomaten aufweist, die mit einem Bauelement-Zuführsystem ausgestattet sind, welches eine eindeutige Zuordnung zwischen Gebinde und Bauelement-Zuführvorrichtung gewährleistet.

Figur 2 zeigt eine perspektivische Ansicht eines als Spulenkörper ausgebildeten Gebindes, auf dem ein mit elektronischen Bauelementen befüllter Bauelement-Gurt aufgewickelt ist.

Figur 3 zeigt ein Bauelement-Zuführsystem, welches eine Zuführvorrichtung und eine Gebinde-Aufnahmevorrichtung aufweist, die über einen Gurtleitkanal mechanisch miteinander gekoppelt sind.

An dieser Stelle bleibt anzumerken, dass sich in der Zeichnung die Bezugszeichen von gleichen oder von einander entsprechenden Komponenten lediglich in ihrer ersten Ziffer und/oder durch einen angehängten Buchstaben unterscheiden.

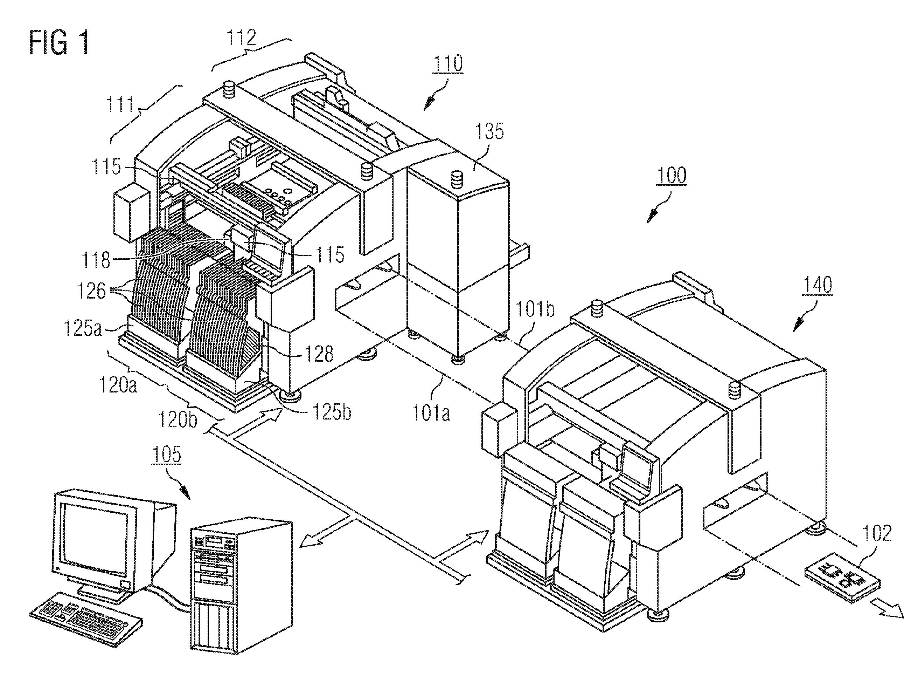

Figur 1 zeigt ein Bestücksystem 100, welches einen ersten Bestückautomaten 110 und einen zweiten Bestückautomaten 140 aufweist. Die beiden Bestückautomaten 110, 140 sind mittels einer Transportstrecke 101 miteinander verbunden. Die Transportstrecke 101 dient der Zuführung bzw. der Abführung von Leiterplatten 102, die in jeweils einem Bestückbereich der Bestückautomaten 110 und 140 mit elektronischen Bauelementen bestückt werden.

Gemäß dem hier dargestellten Ausführungsbeispiel sind die beiden Bestückautomaten 110, 140 sog. Doppelspur Bestückautomaten 110, 140, die jeweils eine vordere Plattform 111 und eine hintere Plattform 112 aufweisen. Aus Gründen der Übersichtlichkeit ist lediglich der erste Bestückautomat 110 so detailliert dargestellt, dass die nachfolgend beschriebenen Ausführungsbeispiele der Erfindung deutlich zu erkennen sind.

Entsprechend des zweiteiligen Aufbaus der beiden Bestückautomaten 110, 140 weist die Leiterplatten-Transportstrecke 101 zwei Transportspuren, eine erste Transportspur 101a und eine zweite Transportspur 101b auf, welche jeweils einer Plattform 111 bzw. 112 zugeordnet sind. Der gesamte Bestückablauf wird von einer zentralen Steuerungseinrichtung 105 gesteuert, die über eine entsprechende Datenverbindung mit den beiden Bestückautomaten 110, 140 verbunden ist.

Wie aus Figur 1 ersichtlich, weist der Bestückautomat 110 ein Flächen-Positioniersystem 115 auf, mit dem ein Bestückkopf 116 innerhalb einer horizontalen xy-Ebene bewegt werden kann. Der Bestückkopf ist der vorderen Plattform 111 des Bestückautomaten 110 zugeordnet. Mittels des Bestückkopfes 116 können in bekannter Weise Bauelemente von zwei Bauelement-Zuführsystemen 120a, 120b abgeholt, in einen Bestückbereich des Bestückautomaten 110 transportiert und auf einer Leiterplatte aufgesetzt werden, die sich gerade in dem Bestückbereich befindet. Um eine präzise Bestückposition zu gewährleisten, ist ferner eine Bauelement-Kamera 118 vorgesehen, mittels welcher in bekannter Weise die Positionen der von dem Bestückkopf 116 aufgenommenen Bauelemente mit hoher Genauigkeit erfasst werden können.

Der Bestückautomat 110 umfasst ferner ein nicht dargestelltes weiteres Flächen-Positioniersystem, mit dem ein weiterer Bestückkopf positioniert werden kann. Der weitere Bestückkopf ist der hinteren Plattform des Bestückautomaten 110 zugeordnet.

Das Bauelement-Zuführsystem 120a bzw. 120b weist jeweils eine Gebinde-Aufnahmevorrichtung 125a bzw. 125b auf. Die Gebinde-Aufnahmevorrichtungen 125a und 125b sind in eine Mehrzahl von einzelnen fächerartigen Aufnahmebereichen 126 aufgeteilt. In die Fächer 126 kann jeweils ein als Spulenkörper ausgebildetes Gebinde eingestellt werden, auf dem in bekannter Weise ein Bauelement-Gurt aufgewickelt ist. In dem aufgewickelten Gurt sind in sog. Bauelement-Taschen elektronische Bauelemente aufbewahrt.

Die Gebinde-Aufnahmevorrichtungen 125a und 125b sind jeweils mit einer Sende- und Empfangseinrichtung 128 ausgestattet, welche mit RFID-Chips kommunizieren können, die an den Spulenkörpern angebracht sind. Dadurch können bauelement-bezogene Daten direkt von dem jeweiligen Gebinde erfasst und an die zentrale Steuerungseinrichtung 105 übertragen werden. Diese kann diese Daten bei der Steuerung des gesamten Bestückablaufs berücksichtigen und so zu einer effizienten Bestückung mit möglicht kurzen Stillstandszeiten beitragen.

Wie ferner aus Figur 1 ersichtlich, umfasst der Bestückautomat 110 ein Magazin-Zuführsystem 135, mit dem in Flächenmagazinen aufbewahrte Bauelemente einem in der hinteren Plattform Bestückprozess zugeführt werden.

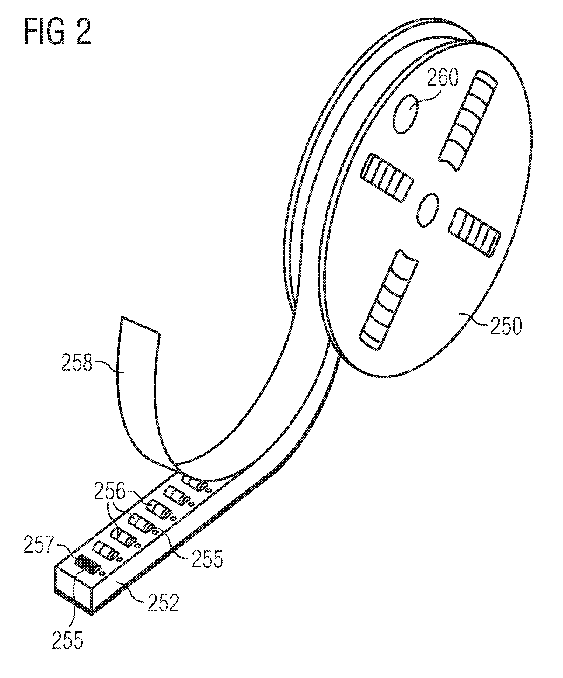

Figur 2 zeigt eine perspektivische Ansicht eines Gebindes 250, welches als Spulenkörper 250 ausgebildet ist. Auf dem Spulenkörper 250 ist ein Bauelement-Gurt 252 aufgewickelt, welcher eine Vielzahl von Ausnehmungen 255 aufweist. Die Ausnehmungen 255 dienen vorwiegend der Aufnahme von jeweils einem elektronischen Bauelement 256. Zumindest eine der Ausnehmungen dient der Aufnahme eines Datenträgers 257, welcher berührungslos ausgelesen werden kann. Gemäß dem hier dargestellten Ausführungsbeispiel ist der Datenträger ein RFID-Chip 257, in dem bauelement-bezogene Daten gespeichert sind. So kann der RFID-Chip 257 beispielsweise die Information enthalten, wie viele Bauelemente noch in dem betreffenden Bauelement-Gurt 252 vorhanden sind. Ebenso können Informationen über den Bauelement-Typ gespeichert sein, welcher in dem Gurt 252 aufbewahrt ist. Insbesondere im Falle der Aufnahme von unterschiedlichen Bauelement-Typen in dem Gurt 252 können mehrere Datenträger 257 verwendet werden, die beispielsweise jeweils am Anfang einer Reihe eines bestimmten Typs eine entsprechende Information über den Bauelement-Typ und/oder die Anzahl der Bauelemente dieses Typs enthalten.

Der Bauelement-Gurt 252 wird in bekannter Weise mittels einer Bauelement-Zuführvorrichtung hin zu einer Bauelement-Aufnahmeposition transportiert, so dass die Bauelemente 256 sequentiell von einem Bestückkopf entnommen werden können. Um ein unbeabsichtigtes Herausfallen der Bauelemente zu verhindern, ist zusätzlich eine Abdeckfolie 258 vorgesehen, welche erst kurz vor der Aufnahmeposition mittels eines geeigneten Abzugsmechanismus von dem Gurt 252 entfernt wird.

An dem Spulenkörper 250 ist ein als RFID-Chip ausgebildetes kontaktloses Übertragungselement 260 angebracht, in dem bauelement-bezogene Daten der Bauelemente 256 gespeichert sein können. Der RFID-Chip 260 kann beispielsweise dazu verwendet werden, um automatisch mittels geeigneter RFID-Lesegeräte die genaue Position des Gebindes 250 innerhalb einer Gebinde-Aufnahmevorrichtung mit mehreren Aufnahmebereichen festzustellen.

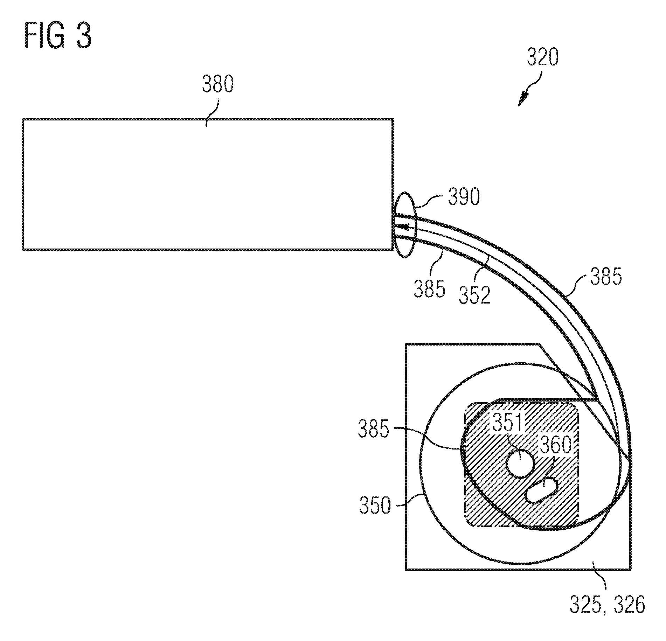

Figur 3 zeigt in einer Querschnittsdarstellung ein Bauelement-Zuführsystem 320, welches eine Gebinde-Aufnahmevorrichtung 325 und eine Bauelement-Zuführvorrichtung 380 aufweist.

In einem Aufnahmebereich 326 der Gebinde-Aufnahmevorrichtung 325 befindet sich ein Spulenkörper 350. Der Spulenkörper 350 weist eine Achse 351 auf, auf die ein mit elektronischen Bauelementen befüllter Bauelement-Gurt 352 aufgewickelt ist. An einer seitlichen Wand des Spulenkörpers 350 ist ein als RFID-Chip ausgebildetes kontaktloses Übertragungselement 360 angebracht. Der RFID-Chip 360 kann dazu verwendet werden, um mittels einer geeigneten RFID-Leseeinrichtung direkt von dem Gebinde 350 bauelement-bezogene Daten auszulesen, welche ggf. bei der Steuerung eines Bestückungsprozesses verwendet werden können.

Gemäß dem hier dargestellten Ausführungsbeispiel wird die Zuordnung zwischen dem Aufnahmebereich 326 und der Bauelement-Zuführvorrichtung 380 auf mechanische Weise durch ein Führungselement 385 gewährleistet. Das Führungselement 385 ist derart ausgeformt, dass der Transportweg des Bauelement-Gurts 352 von dem Gebinde 350 hin zu der Bauelement-Zuführvorrichtung 380 fest vorgegeben ist. Das Führungselement stellt somit einen mechanischen Gurtleitkanal 385 dar, welcher sicherstellt, dass der Bauelement-Gurts 352 nicht einer falschen Bauelement-Zuführvorrichtung 380 zugeführt wird.

Wie aus Figur 3 ferner ersichtlich, weist das Bauelement-Zuführsystem 320 zusätzlich eine Antenne 390 auf. Die Antenne 390 weist eine Ringform auf, welche den Gurtleitkanal 385 umgibt. Auf diese Weise kann mittels der Antenne 390 der in Figur 2 dargestellte Datenträger 257 ausgelesen werden, in dem beispielsweise Informationen über den Typ und/oder die Anzahl der in dem Bauelement-Gurt 352 enthaltenen elektronischen Bauelemente abgespeichert sind. Zu diesem Zweck kann die Antenne 390 mit einer entsprechenden Leseeinrichtung gekoppelt sein, die diese bauelementbezogenen Daten an eine zentrale Steuereinheit eines Bestückautomaten übermittelt.

Der Datenträger kann in einem Endbereich des Bauelement-Gurtes 352 angeordnet sein. Eine Erfassung dieses Datenträgers mittels der Antenne 390 kann beispielsweise eine Bedienperson anweisen, rechtzeitig einen weiteren Gurt 352 anzukoppeln, so dass die erforderlichen Bauelemente nicht ausgehen und eine unterbrechungsfreie Bereitstellung von Bauelementen und damit eine quasi-kontinuierliche Bestückung möglich ist.

Die Verwendung eines Gurtleitkanals 385 hat den Vorteil, dass durch ein geeignetes Einfädeln des Gurtes 352 in den Gurtleitkanal 385 eine zusätzliche lückenlose Sicherstellung der Zuordnung zwischen (a) einem Gebinde 350 bzw. den darin befindlichen Bauelementen und (b) einer Bauelement-Zuführvorrichtung 380 bzw. der entsprechenden Zuführspur gewährleistet werden kann. Der Gurtleitkanal 385 ist dabei derart ausgebildet, dass er sich nicht zur Seite weg bewegen kann. Ferner kann der Gurtleitkanal 385 an seinem unteren Ende derart ausgebildet sein, dass er an der Gebinde-Aufnahmevorrichtung 325 eingehängt und damit lösbar fixiert werden kann.

Durch die Verwendung des Gurtleitkanals 385 wird somit eine hohe Sicherheit bezüglich der Rüstung eines Bestückautomaten geschaffen. Auf diese Weise wird eine weitere Rüstkontrolle, die beispielsweise ein manuelles Einlesen (a) eines Barcodes an einem Gebinde 350 und (b) eines Barcodes an einer Zuführvorrichtung 380 bzw. einer Zuführspur umfasst, nicht mehr erforderlich ist.

Die Kommunikation zwischen einer Sende- und Empfangseinrichtung und dem RFID-Chip 257 schafft zudem die Möglichkeit, dass insbesondere bauelement-bezogene Daten aktualisiert werden können. Eine Manipulation der Zuordnung zwischen Gebinde 350 und Bauelement-Zuführvorrichtung 380 kann somit sowohl durch den Gurtleitkanal 385 auf mechanische Art und Weise als auch durch eine geeignete RFID-Überwachung mittels der Antenne 390 auf elektronische Weise ausgeschlossen werden.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 100: Bestücksystem
- 101: Transportstrecke
- 101a: erste Transportspur
- 101b: zweite Transportspur
- 102: Leiterplatte
- 105: zentrale Steuerungseinrichtung
- 110: Bestückautomat
- 111: vordere Plattform
- 112: hintere Plattform
- 115: Flächen-Positioniersystem
- 116: Bestückkopf
- 118: Bauelement-Kamera
- 120a: Bauelement-Zuführsystem
- 120b: Bauelement-Zuführsystem
- 125a: Gebinde-Aufnahmevorrichtung
- 125b: Gebinde-Aufnahmevorrichtung
- 126: Aufnahmebereiche / Fächer
- 128: Sende- und Empfangseinrichtung
- 135: Magazin-Zuführsystem
- 140: Bestückautomat

- 250: Gebinde / Spulenkörper
- 252: Bauelement-Gurt
- 255: Ausnehmungen / Bauelement-Taschen
- 256: Bauelemente
- 257: Datenträger / RFID-Chip
- 258: Abdeckfolie
- 260: kontaktloses Übertragungselement / RFID-Chip

- 320: Bauelement-Zuführsystem
- 325: Gebinde-Aufnahmevorrichtung
- 326: Aufnahmebereich / Fach
- 350: Gebinde / Spulenkörper
- 351: Achse des Spulenkörpers
- 352: Bauelement-Gurt
- 360: kontaktloses Übertragungselement / RFID-Chip

- 380: Bauelement-Zuführvorrichtung
- 385: Führungselement / Gurtleitkanal
- 390: Antenne

## Patentansprüche

1. Zuführsystem zum sequentiellen Bereitstellen von elektronischen Bauelementen (256) für eine Bestückvorrichtung (110, 140), das Zuführsystem (120a, 120b, 320) aufweisend
• eine Gebinde-Aufnahmevorrichtung (125a, 125b, 325) mit einer Mehrzahl von Aufnahmebereichen (126, 326) zum Aufnehmen jeweils eines mit elektronischen Bauelementen (256) befüllten Gebindes (250, 350),
• zumindest eine Bauelement-Zuführvorrichtung (380) zum sequentiellen Zuführen von in einem Gebinde (250, 350) aufbewahrten Bauelementen (256) und
• ein Führungselement (385),
- welches sich zumindest teilweise von der Bauelement-Zuführvorrichtung (380) zu einem Aufnahmebereich (126, 326) erstreckt,
- welches an der Bauelement-Zuführvorrichtung (380) fixiert ist und
- welches mit einem der Bauelement-Zuführvorrichtung (380) abgewandten Ende mit der Gebinde-Aufnahmevorrichtung (125a, 125b, 325) verbunden ist,
• so dass der Bauelement-Zuführvorrichtung (380) ein bestimmter Aufnahmebereich (126, 326) der Gebinde-Aufnahmevorrichtung (125a, 125b, 325) zugeordnet ist.

2. Zuführsystem nach Anspruch 1, wobei
die Aufnahmebereiche (126, 326) derart geformt sind, dass jeweils ein als Spulenkörper (250, 350) ausgebildetes Gebinde einbringbar ist.

3. Zuführsystem nach einem der Ansprüche 1 bis 2, wobei
das Führungselement (385) einen Kanal aufweist, in dem ein von einem Gebinde (250, 350) abgewickelter und der Bauelement-Zuführvorrichtung (380) zuzuführender Bauelement-Gurt (252, 352) führbar ist.

4. Zuführsystem nach einem der Ansprüche 1 bis 3, zusätzlich aufweisend
• eine Antenne (390), welche relativ zu dem Führungselement (385) derart angeordnet ist, dass ein in dem Bauelement-Gurt (252, 352) befindlicher Datenträger (257) auslesbar ist.

5. Zuführsystem nach Anspruch 4, wobei
die Antenne (390) eine ringartige Form aufweist, welche Form das Führungselement (385) umgibt.

6. Bestückvorrichtung zum Bestücken von Leiterplatten (102) mit elektronischen Bauelementen (256), die Bestückvorrichtung (110, 140) aufweisend
• ein Zuführsystem (120a, 120b) nach einem der Ansprüche 1 bis 5.

7. Verfahren zum Bereitstellen von in einem Bauelement-Gurt (252, 352) aufbewahrten elektronischen Bauelementen (256) an einer Abholposition unter Verwendung eines Zuführsystems (120a, 120b, 320) nach einem der Ansprüche 1 bis 5, das Verfahren aufweisend
• Abwickeln des Bauelement-Gurtes (252, 352) von einem Spulenkörper (250, 350), welcher sich in einem Aufnahmebereich (126, 326) der Gebinde-Aufnahmevorrichtung (125a, 125b, 325) befindet,
• Führen des abgewickelten Bauelement-Gurtes (252, 352) durch das Führungselement (385), und
• Zuführen des geführten Bauelement-Gurtes (252, 352) an die Bauelement-Zuführvorrichtung (380).
